# EUROPEAN PATENT APPLICATION

(11) **EP 4 611 035 A1**
(43) Date of publication of application: **03.09.2025**
(21) Application number: 25157199.8
(22) Date of filing: 11.02.2025
(51) Int. Cl.: H01L 23/48, H01L 21/768

(54) **METHOD FOR MANUFACTURING A REDISTRIBUTION LAYER, AND REDISTRIBUTION LAYER**

(30) Priority: 27.02.2024 IT 202400004186
(71) Applicant: STMicroelectronics International N.V., 1228 Plan-les-Ouates, Geneva (CH)
(72) Inventor: MOLGG, Michele, 20684 AGRATE BRIANZA (MB) (IT); SCIARRILLO, Samuele, 20865 USMATE VELATE (MB) (IT)
(74) Representative: Studio Torta S.p.A.

(57) **Abstract**

Redistribution layer (32) for an integrated circuit (30), comprising: a conductive interconnection layer (33); a conductive body (41) in electrical contact with said interconnection layer (33), the conductive body (41) having a lateral surface and a top surface; a conductive coating layer (42) of Palladium or including Palladium which uniformly covers the lateral surface and the top surface of said conductive body (41) and is absent laterally to the conductive body (41).

## Description

### Technical Field of the Invention

The present invention relates to a method for manufacturing a redistribution layer and to a redistribution layer.

### State of the Art

As is known, integrated circuits (ICs) are composed of various superimposed layers made of semiconductor, insulating and conductive materials, typically defined by photolithography.

In a first step (front end of line, FEOL) of a process for manufacturing an integrated circuit, single devices such as, among others, transistors, diodes, resistors and capacitors are patterned on the surface of a wafer.

In a second step (back end of line, BEOL), the single devices are interconnected by conductive metal lines. In particular, due to the complexity of modern layouts of integrated circuits (ICs) and the high density of single devices, the back end of line process comprises forming several stacked metal layers, electrically insulated from each other by dielectric layers; vias through the dielectric layers allow any metal layer to be connected to the metal layers below and/or to the one above.

In a third step of the process for manufacturing integrated circuits (ICs), belonging to the BEOL step (which allows subsequent packaging processes), a redistribution layer (RDL) is patterned above the last metal interconnection layer. As is known, the redistribution layer is an extra metal layer used to route the input/output pads to other positions in the die area, allowing for easier bonding (e.g. chip-to-chip bonding) during manufacturing of the package. Furthermore, it is a power metal layer capable of reducing the I/O access resistance. As the last metal layer, it is also designed to adapt to the requirements of the packaging process.

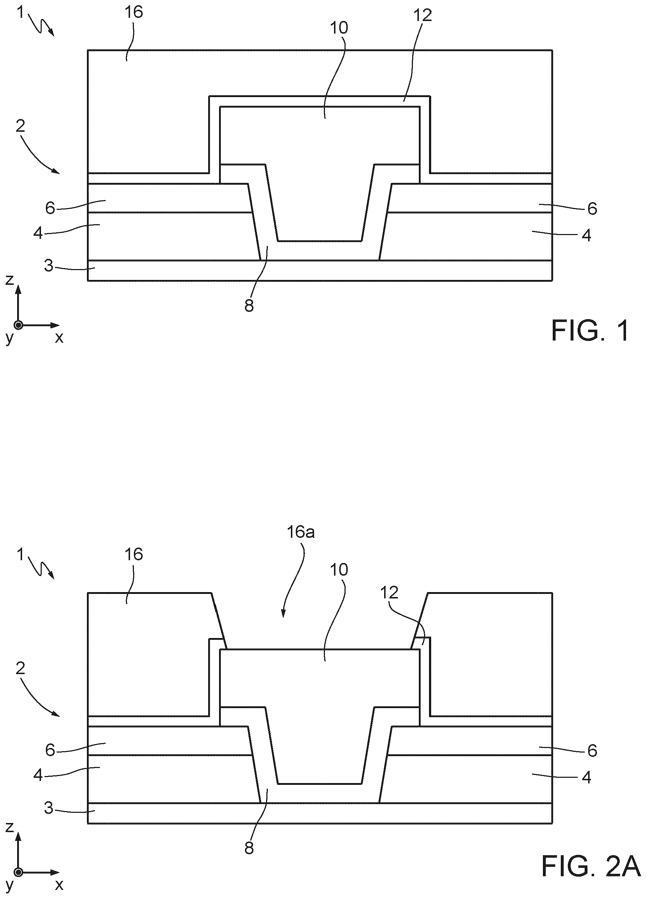

Figure 1 schematically shows a cross-sectional view of a portion of an IC 1 including a pad, which is not explicitly represented and is the region of IC 1 accessed through wire bonding or other contact solutions during the packaging process, and a redistribution layer (RDL) 2 which may be used to provide or acquire electrical signals to/from the pad, according to the prior art. In particular, the IC 1 is represented in a spatial coordinate system defined by three axes x, y, z, orthogonal to each other and the cross-sectional view is taken on an xz plane, defined by the x axis and the z axis. Hereinafter, the thicknesses, depths and heights are intended as measured along the z axis, and the meanings of "top" and "bottom", "above" and "below", are defined with reference to the direction of the z axis.

The IC 1 includes an interconnection layer 3, made of conductive material; the redistribution layer 2 includes a dielectric layer 4 extending above the interconnection layer 3 and a first passivation layer 6 extending above the dielectric layer 4. One or more further layers (not shown) may be present between the interconnection layer 3 and the dielectric layer 4 (for example, in case the layer 3 is of Cu, a further SiN layer which protects the Cu metallization may be present between the interconnection layer 3 and the dielectric layer 4).

The redistribution layer 2 further comprises a barrier region 8, extending above a top surface of the first passivation layer 6 and throughout the depth of the first passivation layer 6 and the dielectric layer 4, so as to be in contact with the interconnection layer 3.

The redistribution layer 2 further comprises a conductive region 10, extending onto the barrier region 8. In particular, in a top view of the IC 1, the conductive region 10 extends within the area defined by the barrier region 8.

The barrier region 8 and the conductive region 10 form a conductive path from the interconnection layer 3 to the top surface of the first passivation layer 6.

The redistribution layer 2 further comprises a coating region 12, extending above the first passivation layer 6, around the conductive region 10 and the barrier region 8, and above the conductive region 10. The coating region 12 is in contact with the top surface of the first passivation layer 6, the conductive region 10 and the barrier region 8. Far from the pad, the coating region 12 completely covers the conductive region 10.

In other words, the coating region 12 completely covers the portions of the barrier region 8 and the conductive region 10 extending above the first passivation layer 6.

The redistribution layer 2 further comprises a second passivation layer, or photosensitive insulation layer, 16 (for example, polyimide, PBO, epoxy material, etc.), completely covering the coating region 12 far from the pad.

In particular, a convenient choice of conductive materials for the redistribution layer 2 is such that the conductive region 10 is made of copper (Cu), the coating region 12 is made of silicon nitride with a thickness of about 0.5-1 µm. Other thicknesses may be chosen, according to the needs.

At the pad location, the conductive region 10 may be electrically contacted by wire bonding or, alternatively, by a conductive pillar (e.g., of copper) grown on the conductive region 10 (e.g., by electroplating) through an opening formed through the second passivation layer 16 and the coating layer 12, as shown in Figure 2A.

With reference to Figure 2A, features common to those of Figure 1 are identified with the same reference numbers. Here, the conductive region 10 is covered by the coating layer 12 of silicon nitride and the passivation layer 16. The passivation layer 16 extends laterally to, and partially above, the conductive region 10 and the coating layer 12. In particular, the passivation layer 16 has a top opening 16a aimed at allowing access to the conductive region 10. The conductive region 10 may be electrically and physically accessed through this opening 16a after a step of etching away the portion of the coating layer 12 exposed through the opening 16a.

After removing such portion of the coating layer 12, the conductive region 10 is electrically accessible to perform electrical tests, in particular EWS ("Electrical Wafer Sorting") tests, functional tests or other reliability tests. In order not to damage, or cause corrosion/oxidation of the exposed part of the conductive region 10, the EWS test should be conducted at low temperatures (generally, ambient temperature or lower). This limits the number and typology of tests that may be performed. Furthermore, despite all the care taken during these steps, the copper surface still undergoes oxidation/corrosion phenomena before, during and/or after the EWS tests, which generates a general degradation of the surface of the conductive region 10.

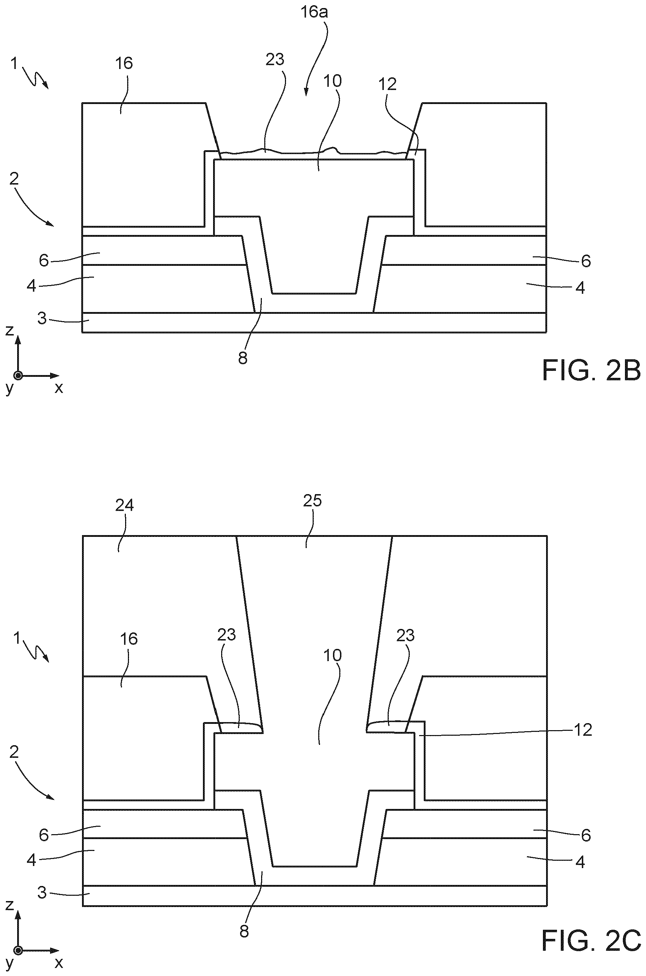

As shown in Figure 2B, an undesired layer 23 (e.g., an oxidized or corroded layer) is shown extending not only onto the exposed copper surface, but also partially under the coating layer 12 (not shown in the Figure).

Figure 2C shows further manufacturing steps to package the IC 1, wherein a molding layer 24 is deposited within the opening 16a on the conductive region 10 (and at least partially on the undesired layer 23). The molding layer 24 is opened at the conductive region 10 (for example, through a LASER drilling process) to reach the conductive region 10. The undesired layer 23 and possibly the conductive region 10 are also partially removed through the LASER drilling process, to expose the underlying copper surface on which an electroplating copper growth process may be performed, to grow the thick copper pillar 25 that provides electrical access to the redistribution layer 2.

During the manufacturing, the steps between the front-end process (Figure 2A) and the back-end process (Figure 2C) entail several corrosion issues of the Cu material, which is not passivated. Such corrosion phenomena may also negatively evolve later during the working life of the device.

As shown in Figure 2C, the non-removed portions of the molding layer 24 are coupled at least in part onto a residual portion of the undesired layer 23. The presence of the undesired layer 23 under the protection layer 12 and/or under the molding layer 24 may cause an irreversible detachment of the protection layer 12/molding layer 24 from the conductive region 10 during further manufacturing steps or, more dangerously, during the working life of the device thus manufactured. In fact, the layer 23 is not of a stable material and may be subject to environmental contamination, such as Cl, SO₄ or Fluorine compounds, capable of generating further corrosion of the RDL metallization.

The aim of the present invention is to provide a method for manufacturing a redistribution layer and a redistribution layer, to overcome the issues previously illustrated.

### Summary of the Invention

According to the present invention, a method for manufacturing a redistribution layer and a redistribution layer are provided, as defined in the annexed claims.

### Brief Description of the Figures

For a better understanding of the present invention, preferred embodiments thereof are now described, purely by way of non-limiting example and with reference to the attached drawings, wherein:
- Figure 1 is a cross-sectional view of a portion of an integrated circuit including a redistribution layer, according to the prior art;
- Figures 2A-2C show manufacturing steps of the redistribution layer of Figure 1, according to the known technique;
- Figure 3A is a cross-sectional view of a portion of an integrated circuit including a redistribution layer, according to an embodiment of the present invention, in an intermediate manufacturing step;
- Figure 3B is a cross-sectional view of the portion of Figure 3A, in a different manufacturing step;
- Figure 3C is a cross-sectional view of the portion of Figure 3A, in a different manufacturing step and alternative to Figure 3B;
- Figures 4A-4H are cross-sectional views of steps for manufacturing the redistribution layer of Figure 3A;
- Figure 5 is a cross-sectional view of a portion of an integrated circuit including a redistribution layer, according to the embodiment of Figure 3A, at a different section of the integrated circuit and in the manufacturing step of Figure 3A;
- Figures 6 and 7 are respective cross-sectional views of a portion of an integrated circuit including a redistribution layer, according to respective further embodiments of the present invention, in a respective intermediate manufacturing step.

### Detailed Description of Embodiments of the Invention

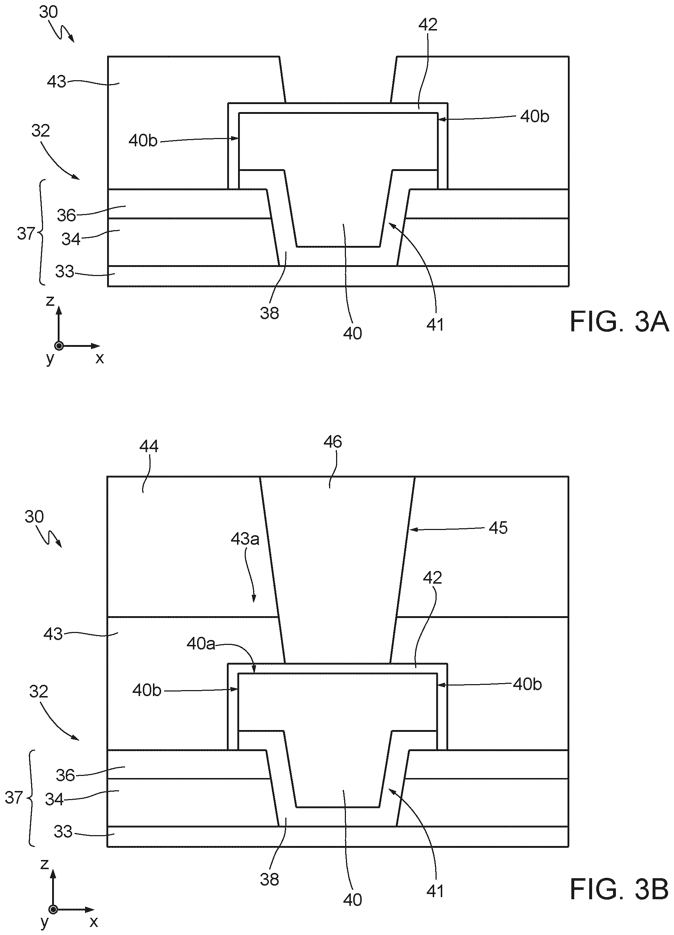

Figure 3A shows an integrated circuit, IC, 30 (only a portion of which is shown in the drawings), represented in a spatial coordinate system defined by three axes x, y, z, orthogonal to each other and the cross-sectional view is on an xz plane, defined by the x axis and the z axis (similarly to Figure 1 and Figures 2A-2C). Hereinafter, thicknesses, depths and heights are intended as measured along the z axis, and the meanings of "top" and "bottom", "above" and "below" are defined with reference to the direction of the z axis (e.g., such terms refer to respective views on the xy plane or on a plane parallel to the xy plane).

Figure 3A schematically shows a cross-sectional view of a portion of the IC 30 comprising a redistribution layer (RDL) 32.

The IC 30 further comprises an interconnection layer 33, made of conductive material such as aluminum or copper. In particular, the interconnection layer 33 is the last metal line (i.e., the outermost metal line among all the metal lines of the IC 30) of the BEOL step of the manufacturing of the IC 30.

The redistribution layer 32 may include a dielectric layer 34 extending above the interconnection layer 33 and a passivation layer 36 extending above the dielectric layer 34. One or more further layers (not shown) may be present between the interconnection layer 33 and the dielectric layer 34; for example, in case the layer 33 is of metal such as Copper (Cu), a further SiN layer, which protects the metal (Cu), may be present between the interconnection layer 33 and the dielectric layer 34. In particular, the dielectric layer 34 is made of an insulating material, such as silicon dioxide (SiO₂), or a multi-stack dielectric material made of SiN and SiO₂; the passivation layer 36 is made of an insulating material, such as silicon nitride (SiN).

The dielectric layer 34 and the passivation layer 36 may be replaced by a single layer of insulating or dielectric material. Therefore, hereinafter, the term "insulating layer 37" refers either to the stack composed of the dielectric layer 34 and the passivation layer 36, or to a stack formed by more than two layers (for example, three layers), or otherwise a single layer.

The redistribution layer 32 further comprises a barrier region 38 of conductive material. The barrier region 38 extends throughout the thickness of the insulating layer 37, so as to be in contact with the interconnection layer 33.

The redistribution layer 32 further comprises a conductive region 40 (in particular of Copper, Cu), extending onto the barrier region 38, and having a top surface 40a and a lateral surface (or wall) 40b. In particular, in a top view of the IC 30, not shown in the Figures, the conductive region 40 extends only within the area defined by the barrier region 38. Hereinafter, the term "conductive body" refers to a stack 41 including the barrier region 38 and the conductive region 40. The barrier region 38 has the function of avoiding the diffusion of copper below the conductive region 40 (for example within the insulating layer 37).

The conductive body 41 forms a conductive path from the interconnection layer 33 to the top surface of the insulating layer 37.

In one embodiment, the barrier region 38 is of a conductive material, for example one of: titanium (Ti), titanium-tungsten (TiW), titanium nitride (TiN), tantalum nitride (TaN), tantalum (Ta), or a stack including two or more of the above-mentioned materials (e.g., TaN/Ta).

In one embodiment, the barrier region 38 has a thickness comprised for example between 270 nm and 330 nm.

In one embodiment, the conductive region 40 is made of conductive material, in particular, as mentioned, Copper (Cu) (alternatively it may be aluminum), and has a thickness comprised for example between 8 µm and 12 µm.

The redistribution layer 32 further comprises a coating layer 42 which covers the conductive body 41 upwardly and laterally; in particular, the coating layer 42 extends around the conductive body 41 uniformly covering the lateral surface 40b and the top surface 40a of the conductive region 40, with coverage continuity between the lateral surface 40b and the top surface 40a. The coating layer 42 also extends onto the exposed lateral walls of the barrier region 38.

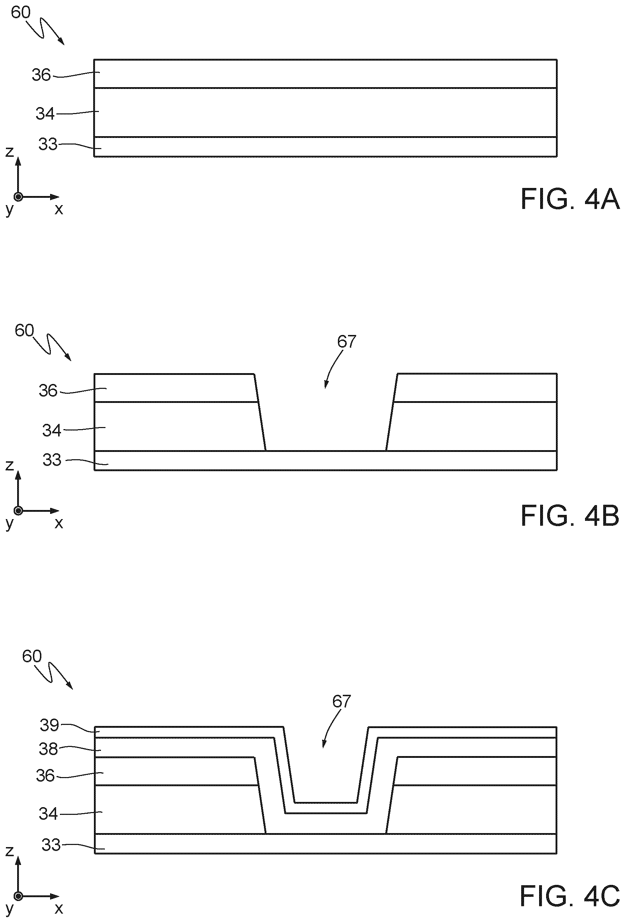

In one embodiment, the coating layer 42 extends continuously, without interruptions, onto the metal material of the conductive region 40 and the barrier region 38. In particular, the coating layer 42 is absent laterally to the conductive body 41, i.e. it is absent above the passivation layer 36 (as better discussed with reference to Figures 4A-4H, the coating layer 42 is formed by Electroless (or "e-less") Deposition ED, also known as electroless plating; this e-less technique allows the formation of the coating layer 42 exclusively in contact with the exposed surface of the conductive body 41.

As is known, the e-less technique envisages an reduction-oxidation (redox) process and is based on the deposition of activators of the material that is to be grown to form the coating layer 42 on the surface of the conductive material of the conductive body 41, and the reaction with reactants for growing the material of the coating layer 42.

According to one aspect of the present invention, the coating layer 42 is of a conductive material, in particular metal, even more in particular Palladium (Pd) or a metal alloy including Palladium. The thickness of the coating layer 42 is for example in the range 100-350 nm (boundaries included). The thickness of the coating layer 42 is, more in particular, for example comprised in the range 240-270 nm (boundaries included).

The coating layer 42 has the following features: good conformity, good continuity, good chemical resistance, good mechanical-electrical properties. In particular, the conformity and the continuity directly derive from the choice to form this layer by electroless deposition or electroless plating. The electrical properties and the mechanical-electrical properties are a consequence of the material chosen (Pd, as discussed above).

A further insulating layer 43 extends for example above the insulating layer 37 and above the coating layer 42. This further insulating layer 43 is of a material from among: polyimide, PBO, epoxy material, photosensitive organic material. Other insulating materials, which ensure good adhesion to Palladium, may be chosen. Advantageously, this further insulating layer 43 allows the influence from an electrical point of view of possible defects present in the redistribution layer, for example due to contamination and/or due to possible residues of conductive material present on the passivation layer 36, to be minimized. In an alternative and not-shown embodiment, the further insulating layer 43 may be omitted.

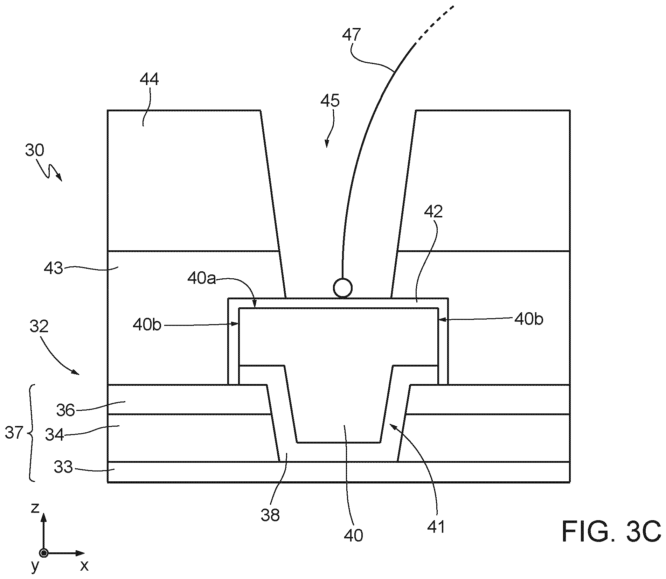

With reference to Figures 3B and 3C, a molding layer 44 may be present above the further insulating layer 43 and, in part, above the coating layer 42. The molding layer 44 has a through hole 45 to provide an electrical contact towards the coating layer 42 and, therefore, the conductive region 40.

With reference only to Figure 3B, a metal (e.g. copper) layer 46 (pillar) extends within the through hole 45, reaching the top surface of the coating layer 42 and thus providing electrical access to the conductive region 40 and to the interconnection layer 33 through the coating layer 42.

With reference only to Figure 3C, which is an alternative to Figure 3B, the pillar 46 is replaced by a wire bonding 47. The molding layer 44 may be omitted.

It should be noted that, in other embodiments of the present invention, not shown in the Figures, further layers or regions may be present at the interface between the further insulating layer 43 and the molding layer 44, with the aim of improving the adherence, or for other manufacturing or electrical requirements.

An EWS ("Electrical Wafer Sorting") test is normally performed after forming the coating layer 42. In particular, according to one aspect of the present invention, the EWS test is performed in a manufacturing step when the conductive layer 40 is completely covered by the coating layer 42. Since the coating layer 42 is of conductive material, the EWS test may be performed by directly electrically contacting the coating layer 42. As is known, the EWS test is performed by using a contact probe or tip of hard material, typically metal, configured to contact a conductive surface. Here, during the EWS test, the contact probe/tip contacts the coating layer 42, without damaging or forming holes thereon. Therefore, during the EWS test, the contact probe/tip is directed onto the coating layer 42 and put into electrical contact with the coating layer 42, establishing the electrical connection required to perform the tests. The surface of the conductive layer 40 is, during testing, protected from corrosion or oxidation phenomena which may occur at high temperatures (up to and above 150°C, for example up to 200-300°C) at which the test may be performed. Other reliability tests, other than EWS tests or in addition to EWS tests, may also be performed in a similar manner.

Figures 4A-4H schematically show a cross-sectional view of steps of a method for manufacturing a redistribution layer according to one embodiment of the present invention; in particular, the method of Figures 4A-4H is a method for manufacturing the redistribution layer of Figure 3A. The redistribution layer is represented in the spatial coordinate system defined by the three axes x, y, z, orthogonal to each other, and the cross-sectional view is taken on an xz plane, defined by the x axis and the z axis.

With reference to Figure 4A, a wafer 60 is envisaged, including the interconnection layer 33. In particular, the interconnection layer 33 is the outermost metallization layer of the back end of line of an integrated circuit. The bottom layers of the integrated circuit are not shown in Figures 4A-4H.

The dielectric layer 34 is formed above the interconnection layer 33. In particular, the dielectric layer 34 is made of an insulating material, such as for example silicon dioxide, and has a thickness comprised for example between 900 nm and 1200 nm.

The passivation layer 36 is formed above the dielectric layer 34. In particular, the passivation layer 36 is made of an insulating material, such as silicon nitride, and has a thickness comprised for example between 500 nm and 650 nm. Hereinafter, the term "insulating layer" refers, as already mentioned, to the stack 37 formed by the dielectric layer 34 and the first passivation layer 36, or to a stack formed by more than two dielectric/insulating layers, or even to a single layer of insulating or dielectric or passivation material.

Then, Figure 4B, a trench, or through via, 67 is formed through the passivation layer 36 and the dielectric layer 34, up to exposing a surface of the interconnection layer 33. For example, the via 67 is formed by known photolithography and dry etching steps, applied at the exposed surface of the first passivation layer 36.

Then, Figure 4C, the barrier layer 38 is formed above the first passivation layer 36, for example by physical vapor deposition (PVD). The barrier layer 38 partially fills the via 67, covering the previously exposed lateral walls of the dielectric layer 34 and the first passivation layer 36 and the previously exposed surface of the interconnection layer 33.

In particular, the barrier layer 38 is of conductive material, such as titanium (Ti), or titanium-tungsten (TiW), or titanium nitride (TiN), or tantalum nitride (TaN), or tantalum (Ta), or a stack including two or more of such materials. Furthermore, the thickness of the barrier layer 38 may be lower than the combined thickness of the dielectric layer 34 and the first passivation layer 36, and in particular is comprised for example between 270 nm and 330 nm. Then, a seed layer 39 is formed above the barrier layer 38, partially filling the via 67. For example, the seed layer 39 is deposited by PVD.

In particular, the seed layer 39 is made of conductive material, such as copper (Cu), and has a thickness comprised for example between 180 nm and 220 nm, such that the via 67 is only partially filled by the seed layer 39.

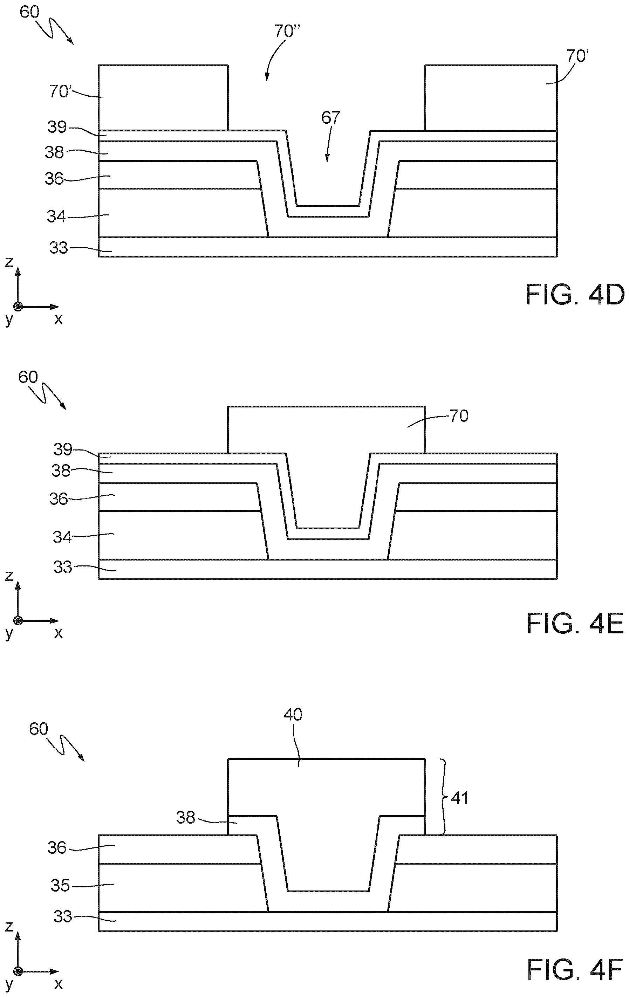

Then, Figure 4D, a photolithographic mask 70' is applied at the exposed surface of the seed layer 39. In particular, the layout of the photolithographic mask 70' is designed considering that the openings in the mask define areas in which a layer will be formed in a subsequent step of the manufacturing method.

In particular, Figure 4D shows an opening 70" of the photolithographic mask 70', the opening 70" being opened on the partially filled via 67 so that the via 67, as well as a region around the via 67, is not covered by the photolithographic mask 70'.

Then, Figure 4E, a conductive layer 70 is formed above the portions of the seed layer 39 not covered by the photolithographic mask 70'. The thickness of the conductive layer 70 is sufficiently high to completely fill the via 67 and partially fill the opening 70" of the photolithographic mask 70'.

In particular, the conductive layer 70 is made of the same conductive material as the seed layer 39, such as copper (Cu), and has a thickness comprised for example between 8 µm and 12 µm.

In particular, the conductive layer 70 is formed by electrodeposition or electroplating. Then, the photolithographic mask 70' is removed by a wet removal process, exposing portions of the seed layer 39 not covered by the conductive layer 70.

Then, Figure 4F, said exposed portions of the seed layer 39, not covered by the conductive layer 70, are removed, for example by wet etching, up to exposing the portions of the barrier layer 38 underlying them. Therefore, the remaining portions of the seed layer 39, covered by the conductive layer 70, form, together with the conductive layer 70, the conductive region 40 of the redistribution layer 32 of Figure 3.

Then, the exposed portions of the barrier layer 38 are removed, for example by wet etching, up to exposing the underlying portions of the first passivation layer 36, without affecting the portions of the barrier layer 38 below the conductive layer 70, for example by using standard photolithography techniques by means of, or directly using, the layer 40 as a mask for the underlying layer 38. As a result, the barrier layer 38 is formed. The step of forming the barrier layer 38 is optional.

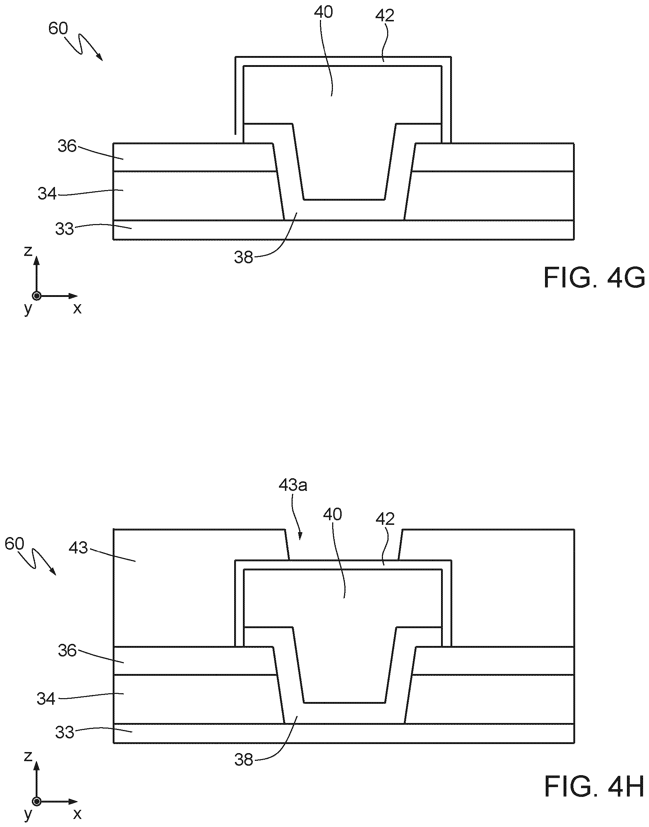

Then, Figure 4G, the coating layer 42 is formed exclusively on the exposed surface of the conductive layer 40. The coating layer 42 is formed, as mentioned, by e-less deposition, so that the coating layer 42 extends uniformly onto the entire exposed surface of the conductive layer 40 without interruptions, and extends exclusively onto the exposed surface of the conductive layer 40 and the barrier layer 38, i.e. it does not proceed laterally to the conductive layer 40 and the barrier layer 38 parallel to the xy plane.

Then, Figure 4H, steps for forming the further insulating layer 43 are performed. For example, the further insulating layer 43 is formed by passivation with a photosensitive organic material deposited by spin coating or lamination. The further insulating layer 43 is selectively etched to form a through opening 43a, which reaches the underlying coating layer 42 and exposes it to the external processing environment.

Then, in a manner not illustrated, the formation of the RDL may be optionally completed by performing a packaging process to obtain the embodiments of Figures 3B and 3C, for example by using a molding material such as, for example, a polymeric material deposited by injection molding, or formed by transfer molding or top gate molding, or other techniques known in the art (thus forming the molding layer 44 of Figures 3B and 3C). The molding layer 44 is formed (for example, deposited) above the insulating layer 43. A step of forming a hole is then performed (e.g., through LASER or other patterning technique), to selectively remove portions of the molding layer 44 and form the access opening 45 towards the coating layer 42.

The steps for forming the molding layer 44 are performed during the back-end process.

A step for forming a conductive connection region 46, having the shape of a pillar (Figure 3B), is then performed. The conductive connection region 46 may be formed by electroplating of metal material (copper), filling the openings 42a, 43a and the through hole 45 with such metal (copper). The conductive connection region 46 thus formed is in electrical contact with the coating layer 42 and, through the latter, with the conductive region 40.

The process described is one of the possible alternatives to form a Copper Direct Interconnect (i.e., provide an electrical connection between die and package without resorting to wire bonding). Alternatives may envisage the use of materials other than molding material for packaging and different techniques for LiSI, such as an aEASI process.

Furthermore, as an alternative to the step of forming a conductive connection region 46 having the shape of a pillar, a wire bonding may be implemented (obtaining the embodiment of Figure 3C). In case of wire bonding, the layer 44 is formed subsequently and partially covers the wire.

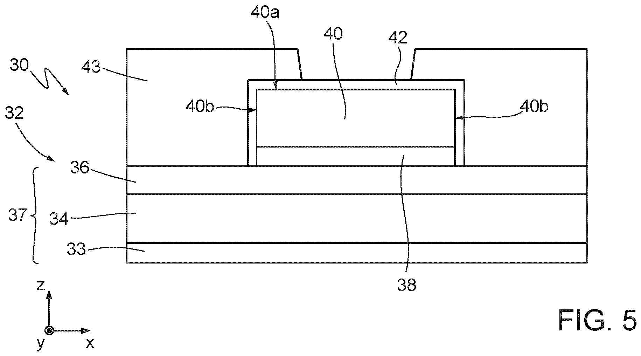

Figure 5 is a cross-sectional view of a portion of the integrated circuit of the present invention, in the same manufacturing step as Figure 3A (similarly, Figure 4H) but at a different region (section) of the integrated circuit. Elements common to those of Figure 3A are identified with the same reference numbers and not further described. In particular, the section of Figure 5 illustrates the conductive body 41 at a portion of the IC 30 without the via 67. Therefore, in this view, the conductive body 41 extends outside the via 67, and is in electrical continuity with regions of the conductive body 41 that extend within the via 67. According to the invention, the lateral surface 40b and the top surface 40a of the conductive region 40 are completely and uniformly covered by the coating layer 42.

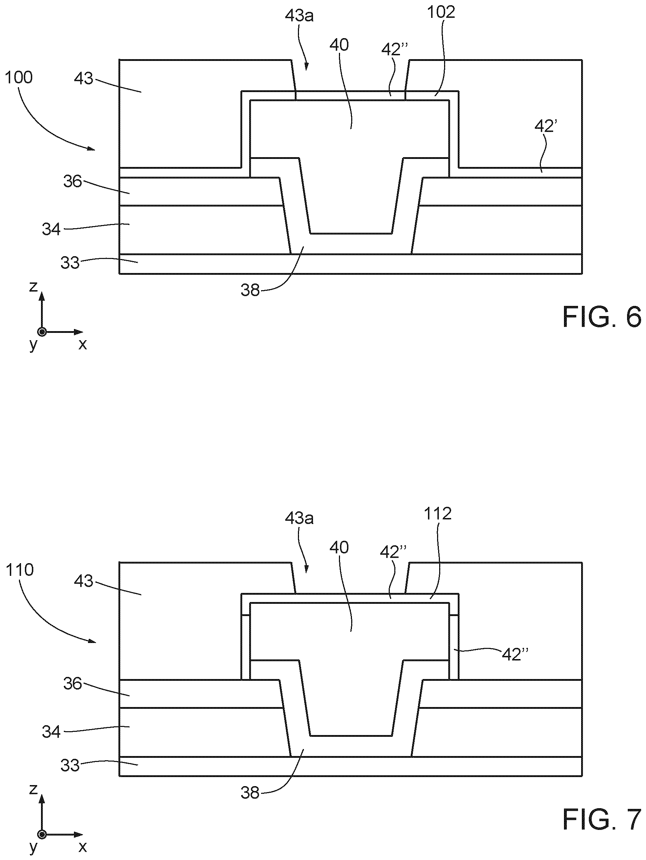

According to a further embodiment of a redistribution layer 100, illustrated in Figure 6, after having performed the manufacturing steps of Figures 4A-4F, a first coating layer 42' is formed on the exposed surface of the conductive body 41, in particular on the lateral surface 40b and on the top surface 40a of the conductive body 41. The first coating layer 42' is formed by depositing a dielectric material, for example SiN, for example by CVD or sputtering. The first coating layer 42' also extends onto the passivation region 36 laterally to the conductive body 41. The first coating layer 42' uniformly and completely covers the lateral surface 40b and the top surface 40a of the conductive body 41.

Steps for forming the insulating layer 43 are then performed, as described with reference to Figure 4H.

Subsequently, after forming the opening 43a through the insulating layer 43, the first coating layer 42' is selectively etched to remove portions of the first coating layer 42' exposed through the opening 43a, until the surface of the conductive layer 40 is exposed to the processing environment.

An e-less deposition step is then performed, similar to what has been previously described, to form a second coating layer 42" exclusively at the surface of the conductive layer 40 exposed to the processing environment. The second coating layer 42" is in particular of conductive material, even more in particular of Palladium or including Palladium.

The redistribution layer 100 of Figure 6 is thus formed, in which the lateral surface 40b of the conductive body 41 is completely and uniformly covered by a dielectric or insulating layer (for example, SiN) and the top surface 40a is at least in part or completely covered by a conductive layer (in one embodiment, Palladium) . The first coating layer 42' may also in part extend above the top surface 40a. The first and the second coating layers 42', 42" are in structural continuity with each other, i.e., they are adjacent to each other. Overall, the first and the second conductive layers 42', 42" form a coating layer indicated as a whole with the reference number 102.

Then, in a manner not illustrated, the method proceeds with the remaining steps for completing the redistribution layer and the integrated circuit accommodating it (for example for forming the electrical connections by using a conductive pillar or wire bonding of Figures 3B and 3C).

In one alternative embodiment of a redistribution layer 110, illustrated in Figure 7, after having formed the first coating layer 42' as described with reference to Figure 6, the method proceeds with the selective removal of the same at the top surface 40a before having formed the insulating layer 43. In this case, an unmasked directive etching (along the Z direction) which removes the first coating layer 42' from both the top surface 40a and the surface of the passivation layer 36. The first coating layer 42' is also partially removed at the lateral surface 40b of the conductive body 41, limitedly to portions of the lateral surface 40b that join with the top surface 40a, and remains at the remaining portions of the lateral surface 40b.

Subsequently, there is formed the second coating layer 42" (of conductive material, in particular Palladium, by using an e-less deposition technique, as already described). The second coating layer 42" extends at the entire top surface 40a and part of the lateral surface 40b, where the conductive material of the conductive body 41 is exposed.

The first and the second conductive layers 42', 42" extend in mutual structural continuity, i.e., they are adjacent to each other. Overall, the first and the second conductive layers 42', 42" form a coating layer indicated as a whole with the reference number 112.

Then, in a manner not illustrated, the insulating layer 43 is formed and the method proceeds with the remaining steps for completing the redistribution layer and the integrated circuit accommodating it (for example for forming the electrical connections by using a conductive pillar or wire bonding of Figures 3B and 3C).

The advantages of the previously described invention, according to the various embodiments, are clear from the preceding description.

In particular, the advantages include saving on manufacturing and production costs, thanks to a simpler manufacturing process compared to the prior art; improved oxidation protection during taping and reduced delamination in case BSM (Back Side Metal) is needed; no risk of unstable EWS test at high temperatures; no risk of contamination of the photosensitive insulating layer 43 during front-end processes and reduced risk of contamination during EWS; no risk of contamination of the conductive layer 40 during front-end (FE) processes and reduced risk of contamination during EWS; low risk of corrosion when the device is stored in a before-uncontrolled environment, during/after EWS and shipping; low risk of corrosion of the conductive layer 40 during back grinding (tape contamination) and around the pad opening (during LiSI or, in general, during direct assembly of Cu interconnections).

A further advantage associated with the embodiment of Figures 3A-5 is that of limiting the copper migration effect and/or the copper protection of the conductive body 41. In fact, the conductive coating layer 42 in a single piece and deposited by e-less deposition technique allows good adhesion of the conductive coating layer 42 to the conductive element 40. In this manner, the formation of vacuum regions between coating layer and conductive element 40 is limited (or avoided), in particular at the interface portion of the latter with the barrier layer 38.

Finally, it is clear that modifications and variations may be made to what has been described and illustrated herein, without thereby departing from the scope of the present invention, as defined in the annexed claims.

For example, the insulating layers 37 and 43 may be of a same material, so that at the end of manufacturing they are in a single insulating region or insulating layer.

In particular, the present invention is advantageous and may be used to protect the conductive layer 40 from corrosion/oxidation phenomena during all steps of the FE (front-end) and BE (back-end) process flow (and between FE and BE), while ensuring electrical testability without degradation or instability of the probe pad (in particular during EWS/PT performed between FE and BE steps).

## Claims

1. A method for manufacturing a redistribution layer (32; 100; 110) for an integrated circuit (30), comprising the steps of:
- forming, on a conductive interconnection layer (33) of a wafer (60), a first insulating layer (37);
- forming a conductive body (41) in electrical contact with said interconnection layer (33), the conductive body (41) having a lateral surface (40b) and a top surface (40a) exposed towards a processing environment;
- forming a conductive coating layer (42; 42") which uniformly covers at least part of the top surface (40a) of said conductive body (41).

2. The method according to claim 1, wherein the step of forming the conductive coating layer (42) also comprises uniformly covering, by said conductive coating layer (42), also the lateral surface (40b) of the conductive body (41), and wherein the conductive coating layer (42) is a single piece of conductive material that extends with structural continuity between the lateral surface (40b) and the top surface (40a) of said conductive body (41).

3. The method according to claim 1, further comprising, prior to forming the conductive coating layer (42"), covering, by a dielectric coating layer (42'), at least part of the lateral surface (40b) of the conductive body (41), and wherein the dielectric coating layer (42') and the conductive coating layer (42") are formed in mutual structural continuity on the conductive body (41).

4. The method according to any of the preceding claims, wherein the conductive coating layer (42; 42") is formed by an electroless, or e-less, deposition process.

5. The method according to any of the preceding claims, wherein the conductive coating layer (42; 42") has a thickness in the range 100-350 nm.

6. The method according to any of the preceding claims, wherein the conductive coating layer (42; 42") is of Palladium or includes Palladium, and wherein the conductive coating layer (42; 42") extends in direct physical contact with the conductive body (41).

7. The method according to any of the preceding claims, wherein the conductive body (41) is, at least in part, of Copper.

8. The method according to any of the preceding claims, further comprising the steps of:
forming, on the conductive coating layer (42; 42"), an insulating layer (43) of a material from among: polyimide, PBO, epoxy material, photosensitive organic material;
exposing the top surface of the conductive coating layer (42; 42") through an opening (45) in the insulating layer (43); and,
forming an electrical contact (46; 47) on the conductive coating layer (42; 42") within the opening (45), including: forming a conductive pillar (46) in electrical contact with the conductive coating layer (42; 42"); or performing a wire bonding (47) operation on the surface of the conductive coating layer (42; 42").

9. A redistribution layer (32; 100; 110) for an integrated circuit (30) comprising a conductive interconnection layer (33), said redistribution layer (32; 100; 110) further comprising:
- a first insulating layer (37) extending on the conductive interconnection layer (33);
- a conductive body (41) in electrical contact with said interconnection layer (33), the conductive body (41) having a lateral surface (40b) and a top surface (40a);
- a conductive coating layer (42; 42") which uniformly covers at least part of the top surface (40a) of said conductive body (41).

10. The redistribution layer according to claim 9, wherein the conductive coating layer (42) also uniformly covers the lateral surface (40b) of the conductive body (41), and wherein the conductive coating layer (42) is a single piece of conductive material which extends with structural continuity between the lateral surface (40b) and the top surface (40a) of said conductive body (41).

11. The redistribution layer according to claim 9, further comprising a dielectric coating layer (42') extending at least in part on the lateral surface (40b) of the conductive body (41), and wherein the dielectric coating layer (42') and the conductive coating layer (42") extend in mutual structural continuity on the conductive body (41).

12. The redistribution layer according to any of claims 9-11, wherein the conductive coating layer (42; 42") has a thickness in the range 100-350 nm.

13. The redistribution layer according to any of claims 9-12, wherein the conductive body (41) is, at least in part, of Copper.

14. The redistribution layer according to any of claims 9-13, wherein the conductive coating layer (42; 42") is of Palladium or includes Palladium, and wherein the conductive coating layer extends in direct physical contact with the conductive body (41).

15. The redistribution layer according to any of claims 10-14, further comprising:
an insulating layer (43) on the conductive coating layer (42; 42"), the insulating layer (43) being of a material from among: polyimide, PBO, epoxy material, photosensitive organic material, the insulating layer (43) having an opening (45) that reaches the top surface of the conductive coating layer (42; 42"); and
an electrical contact (46, 47) extending within the opening (45) and being in electrical contact with the conductive coating layer (42; 42"), said electrical contact (46, 47) including: a conductive pillar (46) or a connection by wire, or wire bonding (47).
